# FASCICULE DE BREVET EUROPEEN

(11) **EP 4 382 977 B1**
(45) Date de publication et mention de la délivrance du brevet: **19.11.2025**
(21) Numéro de dépôt: 23213275.3
(22) Date de dépôt: 30.11.2023
(51) Int. Cl.: G02B 6/13, G02B 6/42, G02B 6/12

(54) **SYSTÈME OPTIQUE COMPRENANT UN TRANSDUCTEUR PHOTO-ÉLECTRIQUE COUPLÉ À UN GUIDE D'ONDE ET PROCÉDÉ DE FABRICATION ASSOCIÉ**
OPTISCHES SYSTEM MIT EINEM AN EINEN WELLENLEITER GEKOPPELTEN PHOTOELEKTRISCHEN WANDLER UND VERFAHREN ZU SEINER HERSTELLUNG
OPTICAL SYSTEM INCLUDING A WAVEGUIDE COUPLED PHOTOELECTRIC TRANSDUCER AND METHOD OF MANUFACTURING THE SAME

(30) Priorité: 05.12.2022 FR 2212742
(43) Date de publication de la demande: 12.06.2024
(73) Titulaire: Commissariat à l'Energie Atomique et aux Energies Alternatives, 75015 Paris (FR)
(72) Inventeur: MICHIT, Nicolas, 38054 Grenoble Cedex 09 (FR); LE MAITRE, Patrick, 38054 Grenoble Cedex 09 (FR)
(74) Mandataire: Cabinet Camus Lebkiri

(56) Documents cités:
- WO-A1-2021/053096
- US-B1- 8 929 697

## Description

### DOMAINE TECHNIQUE DE L'INVENTION

Le domaine technique de l'invention est celui des dispositifs photoniques pour la communication intra et inter-puces.

La présente invention concerne un système optique utilisant un transducteur photo-électrique à semi-conducteurs couplé à un guide d'onde.

### ARRIERE-PLAN TECHNOLOGIQUE DE L'INVENTION

Dans le domaine de la communication inter- ou intra-puces, l'utilisation de la lumière pour remplacer les signaux électriques permet de surmonter des contraintes physiques liées à l'impédance et la taille des interconnexions métalliques, et ainsi, de répondre au besoin de transférer de grandes quantités de données à très grande vitesse.

Les dispositifs ou plateformes photoniques intégrées développés à cet effet comprennent une source de lumière, généralement de dimensions micrométriques, excitée électriquement et capable d'être couplée efficacement à un guide d'onde photonique, lequel conduit la lumière et, ainsi, transporte l'information.

Dans ce contexte, des architectures de diode électroluminescente (ou LED pour « Light Emitting Diode » selon la terminologie anglaise), appelés aussi sources LED ou sources micro-LED, ont récemment été utilisées comme source de lumière. Par rapport à des sources lasers, elles ont en effet l'avantage d'être bas coût et de consommer peu. Il est aussi plus facile de réduire leurs dimensions jusqu'à l'échelle micrométrique.

De telles architectures LED sont généralement formées à partir d'une hétérostructure à base d'un matériau semiconducteur III-V, c'est -à-dire d'un corps composé d'un élément de la colonne III et d'un élément de la colonne V de la classification périodique de Mendeleiv. Par exemple, des sources LED sont formées à base de nitrure de gallium (ou GaN). L'hétérostructure est en outre reliée à deux électrodes métalliques qui permettent, lorsqu'une tension est appliquée entre elles, d'exciter le matériau semiconducteur III-V et de générer l'émission de lumière.

L'utilisation de sources LED pose cependant le problème de coupler efficacement la lumière émise dans un guide d'onde.

Une première difficulté est liée au fait qu'une source LED émet des ondes incohérentes entre elles. Il n'est donc pas possible d'utiliser une technique de couplage dite surfacique, consistant à exploiter des phénomènes d'accord de phase pour choisir le mode de propagation auquel on désire transférer la puissance optique.

Une deuxième difficulté est liée au fait qu'il est souvent nécessaire de choisir pour le guide d'onde un matériau ayant un indice de réfraction inférieur à celui de la LED. La lumière ayant tendance à se propager dans le matériau ayant le plus fort indice de réfraction, il en résulte qu'elle ne peut que très faiblement passer de la LED au guide, cela même si la LED et le guide sont purement accolés l'un à l'autre, ou intégré l'un avec l'autre.

Plus précisément, le confinement de la lumière dans la LED est dû aux indices de réfraction et aux dimensions respectifs de la source LED et du guide d'onde.

Ainsi, le matériau semiconducteur III-V de la LED présente un indice de réfraction supérieur à celui du matériau utilisé pour le guide d'onde : à 532 nm, le matériau semiconducteur III-V GaN a un indice de réfraction d'environ 2,4, alors que le nitrure de silicium SiN généralement utilisé pour le guide d'onde a un indice proche de 2.

Par ailleurs, la LED présente généralement des dimensions beaucoup plus grandes que les dimensions du guide. Par exemple, la source LED peut avoir une étendue transversale de l'ordre de 1 µm x 0,2 µm et le guide une étendue de l'ordre de 150 µm x 0,4 µm.

Pour remédier à cette difficulté et améliorer l'efficacité du couplage du rayonnement émis par la source LED dans le guide d'onde, une solution consiste à former la source LED et le guide à partir d'une même couche de matériau, selon une intégration dite monolithique.

Le document « On-Chip photonic system using suspended p-n junction InGaN/GaN multiple quantum wells device and multiple waveguides », de Wang Y. et al., Applied Physics Letters, 2016 et le brevet US20180267238 décrivent une intégration monolithique planaire d'une source LED et d'un guide d'onde à partir d'une couche de GaN dopé n.

Le document « Waveguide-coupled nanopillar metal-cavity light-emitting diodes on silicon » de Dolores-Calzadilla V. et al., Nature Communication, 2017, décrit une intégration monolithique verticale d'une source LED et d'un guide d'onde à partir d'une couche de InP dopé p. La source LED est alors disposée sur un segment du guide d'onde.

Cependant, utiliser une intégration monolithique ne résout pas le problème qu'une grande partie du rayonnement émis par la source LED n'est pas transmis au guide d'onde, cela du fait que la LED émet un rayonnement aussi dans des régions qui ne sont pas adjacentes à l'extrémité du guide. Sans moyens de collecter et de ramener ce rayonnement vers le guide d'onde, celui-ci est perdu.

Il n'est cependant pas aisé de collecter efficacement ce rayonnement « perdu » car il présente une gamme d'angle élevée, ou, dit autrement, une grande divergence.

Le brevet US20180267238 cité précédemment décrit une cavité formée sous une partie de la source LED et du guide d'onde. Cette cavité permet de former une interface air/GaN favorable à une meilleure exploitation des ondes émises dans la direction verticale par la source LED. Toutefois, les ondes émises latéralement dans la direction opposée au guide d'onde restent inutilisées.

Le document « Waveguide-coupled nanopillar metal-cavity light-emitting diodes on silicon » de Dolores-Calzadilla V. et al., Nature Communication, 2017 cité précédemment décrit le fait d'adapter la structure de la source LED en intégrant la source dans une cavité métallique. Dans cette structure, la cavité est constituée d'un nano pilier en semi-conducteur III-V qui définit la source LED nanométrique. Ce nano pilier est revêtu de métal pour canaliser une grande partie de l'émission spontanée dans le mode fondamental d'un guide d'onde InP.

Le document « Inverse design optimization for efficient coupling of electrically injected optical antenna-LED to a single-mode waveguide », de Andrade et al., Optics Express, 2019, décrit également une structure LED intégrée dans une cavité entourée de métal. Celle-ci agit comme une cavité résonante qui permet d'augmenter l'émission spontanée de la source. La structure est couplée verticalement ou latéralement avec un guide d'onde. Les parois du guide d'onde à proximité de la structure LED sont alors revêtues avec le métal utilisé pour la cavité métallique. Or la présence de métal (de la structure LED ou des électrodes) dans cette zone est généralement à éviter car elle introduit plus de pertes optiques dans la LED ou les guides d'onde.

La publication WO 2021/053096 A1 divulgue un composant d'interconnexion micro-optique comprenant une plateforme optique avec un substrat supportant une structure d'alignement optique destinée à fixer ou aligner un composant optique. La plateforme comprend également un élément de déflexion de lumière de très petit volume, en matériau à indice élevé, possédant une surface réfléchissante courbe permettant de dévier un faisceau lumineux entrant ou sortant du substrat selon un angle compris dans une plage prédéfinie.

Dans le domaine des interconnexions optiques intégrées, il existe donc toujours un besoin d'une source LED capable d'être efficacement injectée dans un guide d'onde.

### RESUME DE L'INVENTION

L'invention offre une solution aux problèmes évoqués précédemment, en permettant que le rayonnement latéral émis vers l'arrière par une source LED micrométrique contrôlée électriquement soit collecté et redirigé vers l'avant de la source LED, là où se situe le guide d'onde. Ainsi, ce rayonnement latéral « arrière » qui normalement n'atteint jamais l'extrémité du guide d'onde est canalisé dans l'ouverture numérique du guide d'onde. De manière symétrique, si le récepteur micrométrique contrôlé électriquement est une photodiode, l'invention permet que le rayonnement émis vers l'avant par le guide d'onde soit collecté et redirigé vers le récepteur micrométrique.

Pour cela, la source LED est intégrée dans une structure réflective de forme cylindro-parabolique configurée pour réfléchir les rayons lumineux provenant de la face arrière de cette source LED et les faire converger en un lieu de foyers situé à l'avant de la source LED et devant l'extrémité du guide d'onde.

Un aspect de l'invention concerne un système optique comprenant un substrat, une structure réflective, un transducteur photoélectrique et un guide d'onde,
- la structure réflective étant formée par un pilier cylindro-parabolique disposé sur le substrat, le pilier cylindro-parabolique étant délimité par une surface cylindrique comprenant une surface latérale parabolique et une surface latérale plane, et par deux faces planes parallèles à un plan du substrat, et comprenant :
   - une première face interne de réflexion de profil parabolique disposée sur la surface latérale parabolique de la surface cylindrique de la structure réflective, la première face interne de réflexion étant définie par une pluralité de sections paraboliques parallèles au plan du substrat, chaque section parabolique étant définie par une parabole présentant un axe optique et un foyer et s'étendant depuis le sommet de la parabole jusqu'à la droite perpendiculaire à l'axe optique et passant par le foyer,
   - une deuxième face interne et une troisième face interne de réflexion planes disposées sur la surface latérale plane de la surface cylindrique de la structure réflective, la deuxième et troisième face interne de réflexion étant orthogonales au plan du substrat et au plan comportant les axes optiques de la pluralité de sections paraboliques et situées de part et d'autre dudit plan comportant les axes optiques au niveau des foyers de la pluralité de sections paraboliques,
- le transducteur photoélectrique comprenant une région active configurée pour émettre des ondes lumineuses ou configurée pour recevoir des ondes lumineuses, et agencé de sorte que la région active est positionnée dans la structure réflective, au niveau d'une partie des foyers de la pluralité de sections paraboliques, le matériau de la structure réflective étant choisi pour être transparent aux ondes lumineuses,
- le guide d'onde présentant une extrémité proximale, une extrémité distale et un axe longitudinal parallèle aux axes optiques de la pluralité de sections paraboliques, et agencé sur le substrat de sorte que l'extrémité proximale est accolée à la structure réflective, entre la deuxième et la troisième face de réflexion et au niveau de la région active.

Grâce à l'invention, la structure réflective présente une première face interne de réflexion de profil parabolique définie par une pluralité de sections paraboliques parallèles au plan du substrat, chaque section parabolique étant définie par une parabole présentant un axe optique et un foyer et s'étendant depuis le sommet de la parabole jusqu'à la droite perpendiculaire à l'axe optique et passant par le foyer.

Ainsi, cette première face interne de réflexion agit comme un miroir parabolique bi-dimensionnel et obéit dans chaque plan parallèle au plan du substrat aux lois d'optique géométrique propres au miroir parabolique.

Ainsi, dans chaque plan parallèle au plan du substrat, la première face interne de réflexion fournit en son foyer (situé sur l'axe optique) une image parfaite d'un point situé à l'infini. Cela signifie que les rayons provenant d'une source de lumière isotrope placée au foyer sont réfléchis (sur cette première face interne de réflexion) parallèlement à l'axe optique. Symétriquement, les rayons lumineux provenant parallèlement à l'axe optique sont réfléchis par la première face interne de réflexion en un point situé au foyer.

L'ensemble des foyers de la pluralité de sections paraboliques définit un segment de droite formant le lieu de foyers de la première face interne de réflexion.

Comme le transducteur photoélectrique comprend une région active configurée pour émettre des ondes lumineuses ou configurée pour recevoir des ondes lumineuses, la région active se comporte comme une source de lumière isotrope ou comme un récepteur de lumière. Par « ondes lumineuses » on entend des ondes ayant au moins une longueur d'onde dans la bande spectrale comprise entre 200 nm et 1200 nm.

Cette région active est positionnée dans la structure réflective, au niveau d'une partie des foyers de la pluralité de sections paraboliques. Ainsi, la région active présente une face latérale (dite face arrière) orientée vers la première face interne de réflexion et située à proximité du lieu de foyers de celle-ci. Dans chaque plan parallèle au plan du substrat, la région active correspond donc à un point situé au niveau du foyer de la section parabolique. D'après ce qui précède, les rayons lumineux qui en sont issus sont réfléchis par la première face interne de réflexion, parallèlement à l'axe optique. Symétriquement, les rayons lumineux provenant sur la première face interne de réflexion parallèlement à l'axe optique sont réfléchis vers la région active.

Par ailleurs, la structure réflective présente une deuxième face interne et une troisième face interne de réflexion planes, orthogonales au plan du substrat et au plan comportant les axes optiques de la pluralité de sections paraboliques.

Ainsi, la deuxième et la troisième face interne de réflexion agissent comme des miroirs plans disposés à l'avant du miroir parabolique bi-dimensionnel dans un plan perpendiculaire au plan du substrat. Cela signifie que, dans chaque plan parallèle au plan du substrat, les rayons lumineux ayant été réfléchis par la première face interne de réflexion parallèlement à l'axe optique sont réfléchis dans la même direction par l'une ou l'autre des deuxième ou troisième face interne de réflexion. D'après ce qui précède, ces rayons lumineux provenant de l'une ou l'autre des deuxième ou troisième face interne de réflexion sont alors dirigés vers la région active par une nouvelle réflexion sur la première face interne de réflexion. Ainsi, les rayons lumineux sont concentrés dans une zone de dimensions équivalentes à celles de la région active. Cela permet d'utiliser un guide d'onde qui présente des dimensions (en section) comparables à celles de la région active sans introduire des pertes de couplage (par rapport aux systèmes dans lesquels la région où sont concentrés les rayons émis par la région active présente des dimensions beaucoup plus grandes que celles de la région active, ou beaucoup plus grandes que les dimensions typiques des guides d'ondes utilisés en optique intégrée).

Le fait que les dimensions de la section du guide d'onde soient comparables à celles de la région active ouvre la voie à un système optique comparable à un guide d'onde monomode, et ayant, donc, des performances améliorées, notamment en termes de guidage.

Le fait que la deuxième face interne et la troisième face interne de réflexion soient situées de part et d'autre du plan comportant les axes optiques au niveau des foyers de la pluralité de sections paraboliques permet que le guide d'onde puisse être accolé à la structure réflective au niveau de la région active et au plus proche des foyers de la structure réflective parabolique. Ainsi, la face de la région active opposée à la face arrière, dite face avant, est accolée ou au moins située à proximité de l'extrémité proximale du guide d'onde. Cela permet d'améliorer le couplage de la lumière entre la région active et le guide d'onde.

Il convient d'ajouter que le fait d'utiliser pour la structure réflective un matériau transparent aux rayons lumineux émis ou reçus par la région active permet de réaliser les faces internes de réflexion à partir d'un pilier plein. L'avantage est qu'un tel pilier peut être réalisé en utilisant des techniques de fabrication microélectroniques standard (structuration de couches par exemple). Dit autrement, l'ensemble du système optique est compatible avec des procédés de fabrication microélectroniques.

Un autre avantage à utiliser un cylindre parabolique plein et transparent intégrant la région active est qu'il existe une continuité d'indice au sein de la structure réflective. Cette continuité d'indice permet de réduire les pertes optiques et contribue donc à améliorer le couplage de la lumière entre la région active et le guide d'onde.

La combinaison de ces différentes caractéristiques permet donc d'obtenir une interconnexion optique intégrée (ou système photonique intégré) dans laquelle le transducteur photo-électrique présente des dimensions comparables à la section du guide d'onde tout en y étant efficacement couplé, puisque les rayons arrières et avant émis par la région active sont collectés, et concentrés, par la structure réflective, à l'entrée du guide d'onde. L'expression « efficacement couplée » désigne le fait que la fraction de la puissance optique transmise au guide d'onde (lorsque le transducteur photo-électrique est une source de lumière) ou au transducteur photoélectrique (lorsque le transducteur photo-électrique est un récepteur de lumière) est augmentée.

Avantageusement, le transducteur photoélectrique comprend une électrode supérieure et une électrode inférieure, l'électrode supérieure étant positionnée sur une face supérieure de la structure réflective à l'aplomb de la zone prédéterminée pour la région active, et présentant des dimensions latérales correspondant aux dimensions prédéterminées pour la région active.

Ainsi positionnée, l'électrode supérieure est située à distance de la région active et de l'extrémité proximale du guide d'onde. Le métal qui la forme n'y engendre pas ou peu de perturbation des rayons lumineux, ce qui diminue les pertes optiques et est favorable à une meilleure efficacité de couplage.

Ainsi, grâce aux deux faces planes parallèles au substrat de la structure réflective, les électrodes du transducteur photoélectrique sont positionnées à l'extérieur de la structure réflective. Cette structure réflective peut donc être formée d'un seul matériau transparent (la région active est définie uniquement par les électrodes du transducteur photoélectrique). Cette continuité de matériau, qui implique une continuité d'indice optique au sein de la structure réflective, permet de minimiser les pertes optiques dans cette structure réflective, et donc d'améliorer le couplage de la lumière dans le guide d'onde.

Il convient ainsi de noter que la position de l'électrode supérieure permet de préserver la transparence de la structure réflective. Par ailleurs, comme la taille et la position de la région active sont définies par la taille et la position de l'électrode supérieure, aucune opération de gravure sur les flancs du transducteur n'est nécessaire, ce qui permet d'utiliser un procédé de fabrication simple.

Avantageusement, un premier milieu est disposé à l'extérieur de la structure réflective dans un espace adjacent à la première face interne de réflexion et un deuxième milieu est disposé à l'extérieur de la structure réflective et du guide d'onde dans l'espace adjacent à la deuxième face interne de réflexion et dans l'espace adjacent à la troisième face interne de réflexion, le premier et deuxième milieu présentant un indice de réfraction strictement inférieur à l'indice de réfraction du matériau transparent choisi pour la structure réflective.

Ainsi, les faces internes de réflexion sont obtenues par une interface entre deux milieux. L'avantage est que ces faces internes de réflexion sont réalisables à partir d'un pilier plein, de façon simple et compatible avec des procédés standards de fabrication microélectronique.

Selon une première variante de réalisation, le premier milieu est formé d'un matériau diélectrique et le deuxième milieu comprend de l'air.

Le matériau diélectrique permet de définir la première face interne de réflexion en même temps qu'il permet d'isoler électriquement les flancs de la structure réflective.

L'air permet de définir la deuxième et la troisième face interne de réflexion sans nécessiter un matériau métallique susceptible de perturber la propagation des rayons lumineux à proximité de la région active et/ou du guide d'onde. En effet, contrairement à la première face interne de réflexion, la deuxième et la troisième face interne de réflexion sont situées à proximité du guide d'onde et la région active, et il est préférable d'éviter tout ajout de métal dans cette zone.

Selon une deuxième variante, le premier et le deuxième milieu sont formés d'un matériau diélectrique.

Le matériau diélectrique permet de définir les faces internes de réflexion en même temps qu'il permet d'isoler électriquement les flancs de la structure réflective.

Avantageusement et de façon compatible avec les deux variantes de réalisation précédentes, un mur de matériau métallique est disposé dans le premier milieu et à proximité de la première face interne de réflexion.

Ainsi, le mur de matériau métallique permet que la première face interne de réflexion travaille en réflexion spéculaire ou réflexion totale. La fraction du rayonnement réfléchi est augmentée par rapport à une interface matériau transparent/milieu diélectrique. Comme cette face est éloignée de la région active et du guide, le mur de métal n'a pas d'impact sur le confinement des rayions lumineux au niveau de la région active ou de l'extrémité proximale du guide d'onde.

Outre les caractéristiques qui viennent d'être évoquées dans le paragraphe précédent, le système optique selon un aspect de l'invention peut présenter une ou plusieurs caractéristiques complémentaires parmi les suivantes, considérées individuellement ou selon toutes les combinaisons techniquement possibles.

Le transducteur photo-électrique est formé d'une jonction P-N et de puits quantiques disposés dans la jonction P-N.

Le matériau de la jonction P-N est un matériau III-V tel qu'un matériau à base de GaN.

Le matériau transparent choisi pour la structure réflective est le matériau de la jonction P-N.

Ainsi, la structure réflective et le transducteur photoélectrique forment une seule pièce pleine présentant un indice de réfraction homogène. L'avantage est que le facteur de mérite de la structure réflective est amélioré, ce qui conduit à une meilleure efficacité de couplage.

Le guide d'onde est formé du matériau de la jonction P-N et des puits quantiques.

Ainsi, le guide d'onde est accolé à la structure réflective sans nécessité de graver les puits quantiques du transducteur photo-électrique. L'avantage est que des problèmes électriques sont évités.

Une couche de matériau métallique est disposée dans le deuxième milieu, à proximité de la deuxième face interne de réflexion et à proximité de la troisième face interne de réflexion.

Ainsi, la deuxième et la troisième face interne de réflexion se comportent comme des surfaces de réflexion totale.

La structure réflective présente une dimension latérale de hauteur dans le plan du substrat strictement supérieure à une taille du guide d'onde.

De préférence, la hauteur est 18 fois supérieure à la taille du guide.

Ainsi, même des rayons lumineux très divergents (ou faisant un grand angle par rapport à l'axe optique de la première face interne de réflexion) sont collectés et redirigés efficacement vers la région active ou le guide d'onde. La structure réflective reste par ailleurs compacte.

Le guide d'onde comprend une extrémité proximale élargie par rapport aux dimensions du guide d'onde.

Cette configuration du guide d'onde permet de coupler plus efficacement la lumière émise par la région active et redirigée vers l'extrémité proximale du guide d'onde par la structure réflective.

Un autre aspect de l'invention concerne un procédé de réalisation d'un système optique selon le premier aspect de l'invention comprenant les étapes de :
- Fourniture d'un substrat comprenant une couche de substrat, une couche tampon agencée sur la couche de substrat et une jonction P-N agencée sur la couche tampon,
- Structuration en trois dimensions de la jonction P-N de sorte à définir une face supérieure du guide d'onde ainsi qu'une partie du pilier cylindro-parabolique formant la structure réflective, la structuration comprenant des sous-étapes de lithographie
- Gravure verticale de la jonction P-N de part et d'autre du pilier cylindro-parabolique formé pour compléter la définition du guide d'onde et du pilier cylindro-parabolique formant la structure réflective, et définir une couche de liaison,
- Passivation par dépôt conforme du premier milieu diélectrique à l'extérieur du pilier cylindro-parabolique, au niveau de la première face interne de réflexion, pour obtenir la structure réflective,
- Formation d'une électrode supérieure sur la face supérieure de la jonction P-N au niveau des foyers de la pluralité de sections paraboliques, et d'une électrode inférieure sur la couche de liaison pour finaliser le transducteur photo-électrique et le système optique.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 représente schématiquement, en vue de dessus, un premier mode de réalisation du système optique,
- La figure 2 montre une vue de dessus agrandie de la structure réflective et du transducteur photo-électrique du système optique de la figure 1,
- La figure 3 est une vue en coupe du système optique de la figure 1,
- La figure 4 représente schématiquement, en vue de dessus, un deuxième mode de réalisation du système optique,
- Les figures 5A à 5E représentent en vue de coupe des étapes ou sous-étapes de fabrication du système optique de la figure 1.

Sauf précision contraire, un même élément apparaissant sur des figures différentes présente une référence unique.

### DESCRIPTION DETAILLEE

Le premier aspect de l'invention concerne le domaine de la photonique intégrée. En particulier, le premier aspect de l'invention concerne un système d'optique guidée, basé sur un transducteur photo-électrique formé par une jonction P-N et intégré latéralement avec un guide d'onde. Le système optique selon l'invention est remarquable notamment en ce qu'il permet d'améliorer le couplage latéral de ce transducteur photo-électrique avec le guide d'onde.

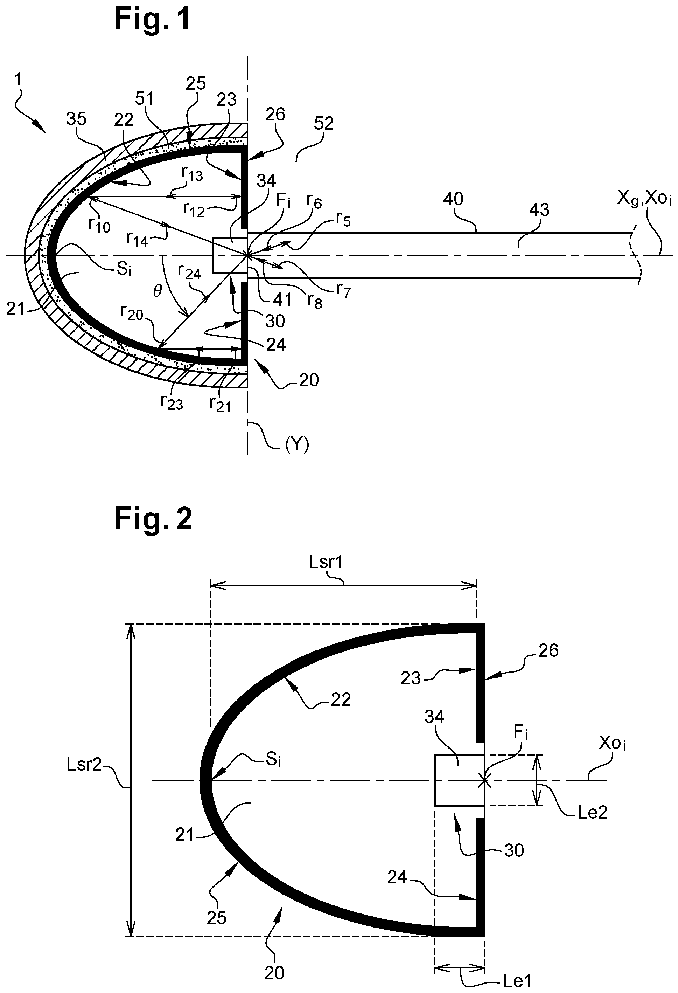

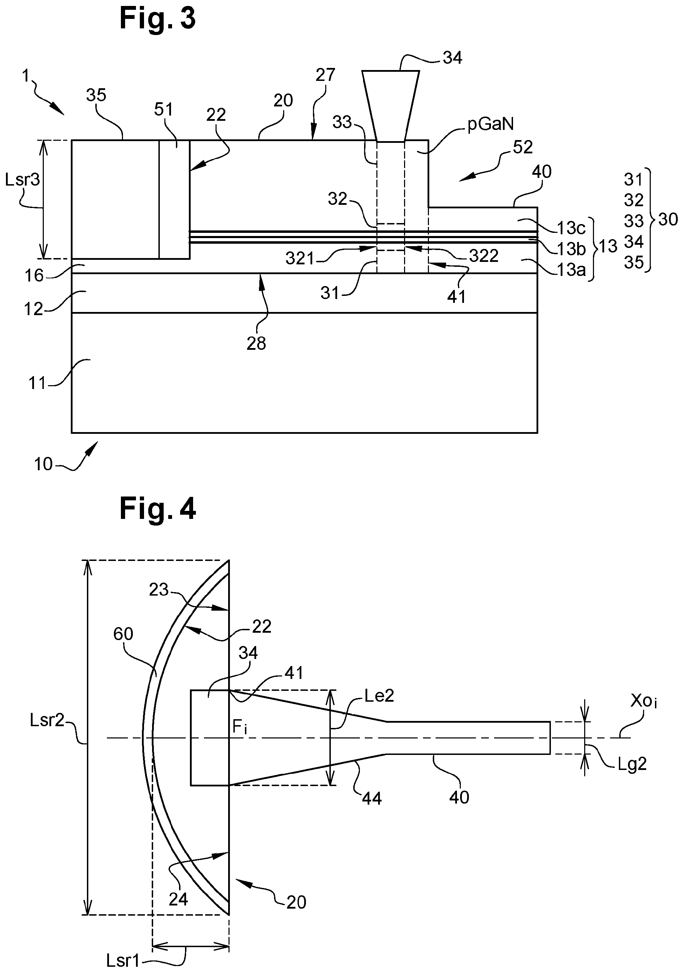

Un premier mode de réalisation du système optique sera décrit en référence à la figure 1, à la figure 2 et à la figure 3.

Un deuxième mode de réalisation sera ensuite décrit en référence à la figure 4.

De façon commune au premier et au deuxième mode de réalisation, le système optique 1 comprend un transducteur photo-électrique 30, un guide d'onde 40 et une structure réflective 20 portés par un substrat 10.

Ces éléments 10, 20, 30 et 40 sont décrits individuellement ci-après.

En référence à la figure 3, le substrat 10 comprend une couche de substrat 11, par exemple une couche de substrat en saphir, une couche tampon 12, par exemple en nitrure d'aluminium, agencée sur la couche de substrat 11. Cette couche tampon 12 porte le transducteur photo-électrique 30, le guide d'onde 40 et la structure réflective 20.

Toujours en référence à la figure 3, le transducteur photo-électrique 30 comprend une région inférieure 31, une région active 32 et une région supérieure 33 formées dans une jonction P-N 13, ainsi que deux électrodes 34,35, l'une, dite électrode supérieure 34, étant reliée à la couche P 13c de la jonction P-N 13 et l'autre, dite électrode inférieure 35, étant reliée à la couche N 13a de cette jonction P-N 13 via une couche de liaison 16.

Le transducteur photo-électrique 30 est un système optique récepteur lorsque la région active 32 est apte à transformer un signal optique (illustré par les rayons r₆ et r₈ sur la figure 1) reçu en provenance du guide d'onde 40 en un signal électrique, ou un système optique émetteur lorsque la région active 32 est apte à générer un signal optique (illustré notamment par les rayons r₅ et r₇ sur la figure 1) en direction du guide d'onde 40 sous l'effet d'un signal électrique. Les signaux électriques sont conduits/appliqués par les électrodes 34,35.

Dans la suite de la description, on considérera un transducteur photo-électrique 30 de type émetteur, présentant donc une région active 32 émettrice. Le principe général de l'invention s'applique cependant naturellement à un transducteur photo-électrique récepteur comprenant une région active 32 réceptrice.

Il convient de noter que les termes « signal optique » ou « ondes lumineuses », désignent des ondes électromagnétiques comprenant au moins une longueur d'onde dans la bande spectrale allant de 200 nm à 1200 nm.

Le matériau du transducteur photo-électrique correspond au matériau 13 formant la jonction P-N.

Ce matériau 13 est un matériau semiconducteur tel qu'un matériau semiconducteur III-V ou un semiconducteur IV-IV, ou encore un semiconducteur II-VI, présentant un indice de réfraction élevé dans la bande spectrale 200 nm - 1200 nm, par exemple supérieur à 2.

De préférence, le matériau 13 du transducteur photo-électrique est un matériau semi-conducteur III-V.

Tel qu'utilisé ici, le terme « matériau semi-conducteur III-V » signifie et inclut tout matériau semi-conducteur qui est au moins principalement composé d'un ou plusieurs éléments du groupe IIIA du tableau périodique (B, AI, Ga, In et Ti) et d'un ou plusieurs éléments du groupe VA du tableau périodique (N, P, As, Sb et Bi). Par exemple, les matériaux semi-conducteurs III-V comprennent, sans s'y limiter, GaN, GaP, GaAs, InN, InP, etc.

Par exemple, le matériau du transducteur photo-électrique est à base de nitrure de gallium GaN. L'indice de réfraction d'un tel matériau est 2,4 à la longueur d'onde de 532 nm.

Les régions inférieure 31, active 32 et supérieure 33 sont respectivement formées dans la couche N 13a, les puits quantiques 13b et la couche P 13c de la jonction P-N 13. Elles sont connectées successivement de bas en haut.

Par exemple, la couche N 13a est une couche nGaN, la couche P 13c est une couche pGaN et les puits quantiques 13b sont formés d'une alternance de couches d' InGaN et de GaN.

La région active 32 est définie par l'électrode supérieure 34 et la configuration de la jonction P-N.

Ainsi, la position et les dimensions latérales de l'électrode supérieure 34 déterminent la position et les dimensions de la région active 32 et des régions supérieures et inférieures 31,32 sur le substrat 10. Dit autrement, l'électrode supérieure 34 définit les dimensions latérales et la position du transducteur photo-électrique 30.

Ces dimensions latérales Le1, Le2 de l'électrode supérieure 34 sont représentées en figure 2. De préférence, elles sont de l'ordre de quelques centaines de nanomètres, par exemple 200 nm ou 400 nm. Par souci de simplicité, la première dimension latérale Le1 peut être prise comme étant égale à la deuxième dimension latérale Le2. Comme il sera décrit un peu plus loin dans la description, les dimensions latérales Le1 et Le2 de l'électrode supérieure 34 sont liées aux dimensions de la structure réflective 20 et sont donc déterminées en fonction des dimensions de cette structure réflective 20.

La configuration de la jonction P-N détermine les propriétés optiques et photoélectriques de la région active 32.

La configuration de la jonction P-N est ainsi choisie pour que la région active se comporte, sous l'effet d'une excitation électrique apportée par les électrodes 34,35, comme une source de lumière ponctuelle et isotrope, cela dans chaque plan parallèle au plan du substrat 10. La longueur d'onde du rayonnement est par exemple située dans le vert, autour de 532 nm.

Le rayonnement émis par la région active 32 dans un plan i parallèle au plan du substrat 10 est illustré en figure 1 en utilisant une description optique géométrique. Le rayonnement est émis avec une grande gamme angulaire Θ, comme l'illustrent les rayons r₁₀, r₂₀, r₅, r₇ représentés en figure 1. Une partie des rayons est émise (par exemple les rayons r₁₀, r₂₀) par une face latérale dite face arrière 321 (cf. figure 3) de la région active 32. Une autre partie est émise par une face latérale opposée à la face arrière 321 (cf. figure 3), dite face avant 322 de la région active 32.

En référence à la figure 1, la structure réflective 20 entoure le transducteur photo-électrique 30 au niveau de l'empilement formé par les régions inférieure 31, active 32 et supérieure 33.

Précisément, la structure réflective 20 forme avec les régions inférieure 31, active 32 et supérieure 33 du transducteur photo-électrique 30 un pilier 20 plein de forme cylindro-parabolique. Dit autrement, le pilier 20 est un cylindre droit tronqué, d'axe et de génératrices perpendiculaires au plan du substrat 10, et admettant pour courbe directrice une parabole d'axe Xₒᵢ parallèle au plan du substrat 10 et ayant pour foyer un point Fᵢ situé sur l'axe Xₒᵢ. Ce cylindre droit est tronqué par un plan parallèle aux génératrices et comprenant le foyer Fᵢ. Le pilier 20 est ainsi délimité par une surface cylindrique comprenant une surface latérale parabolique 25 et une surface latérale plane 26 et par deux faces planes 27, 28 (cf. figure 3) parallèles au plan du substrat 10.

Les deux faces planes 27,28 permettent de placer les électrodes 34,35 du transducteur photoélectrique à l'extérieur de la structure réflective 20, à l'aplomb de la région active du transducteur photoélectrique.

Le matériau 21 choisi pour la structure réflective 20 est un matériau transparent aux ondes lumineuses émises par la région active 32. Il présente un indice de réfraction proche ou égal à l'indice de réfraction du matériau du transducteur photo-électrique dans la gamme de longueur d'ondes 400 nm - 800 nm. Par « proche » on entend que la différence d'indice est inférieure à 0,2.

De préférence, le matériau transparent 21 choisi pour la structure réflective 20 est identique au matériau 13 du transducteur photo-électrique 30. Lorsque que ce dernier est à base de GaN, l'indice de réfraction de la structure réflective est 2,4. Autrement dit, la structure réflective 20 et la région active 32 du transducteur photoélectrique présentent alors le même indice de réfraction. Cela permet de réduire les pertes optiques dans la structure réflective et, donc, d'améliorer le couplage de la lumière entre la région active et le guide d'onde.

La structure réflective 20 comprend à proximité de la surface latérale parabolique 25 une première face 22 interne de réflexion et, à proximité de la surface latérale plane 26, une deuxième face 23 interne de réflexion et une troisième face 24 interne de réflexion.

Plus précisément, comme le montre la figure 1, la première face 22 interne de réflexion s'appuie, ou est disposée, sur la surface latérale parabolique 25 de la surface cylindrique de la structure réflective.

Comme le montre encore la figure 1, la deuxième face interne de réflexion 23 et la troisième face interne de réflexion 24 s'appuient, ou sont disposées, sur la surface latérale plane 26 de la surface cylindrique de la structure réflective. Ces deuxième et troisième faces internes de réflexion sont aussi disposées de part et d'autre des foyers Fi.

La première face 22 interne de réflexion parabolique présente des caractéristiques géométriques analogues à celles de la surface parabolique 25 de la surface cylindrique de la structure réflective. En référence à la figure 1, la première face 22 interne de réflexion présente un profil parabolique défini par une pluralité de sections paraboliques parallèles au plan du substrat 10. Une telle section est illustrée en figure 1. Chaque section parabolique est définie par la parabole présentant l'axe optique Xₒᵢ et le foyer Fᵢ, et s'étend depuis le sommet Sᵢ de la parabole jusqu'à la droite y perpendiculaire à l'axe optique Xₒᵢ et passant par le foyer Fᵢ.

La deuxième face 23 interne et la troisième face 24 interne de réflexion présentent des caractéristiques géométriques analogues à la surface latérale plane 26 de la surface cylindrique de la structure réflective. La deuxième face 23 interne et la troisième face 24 interne de réflexion sont des faces planes, orthogonales au plan du substrat 10 et au plan comportant les axes optiques Xₒᵢ de la pluralité de sections paraboliques. Ces faces 23,24 sont en outre situées de part et d'autre dudit plan comportant les axes optiques Xₒᵢ au niveau des foyers Fᵢ de la pluralité de sections paraboliques.

Les faces internes 22, 23, 24 de réflexion sont aptes à réfléchir vers l'intérieur de la structure réflective 20 les ondes lumineuses émises par la région active à l'intérieur de la structure réflective 20. Dit autrement, les faces internes 22,23 et 24 agissent comme des surfaces semi-réfléchissantes.

Pour cela, un premier milieu 51 est disposé à l'extérieur de la structure réflective 20 dans un espace adjacent à la première face interne 22 de réflexion. Dit autrement, le deuxième milieu 51 enrobe sur toute sa hauteur la surface latérale parabolique 25 de la structure réflective 20. En outre, un deuxième milieu 52 est disposé à l'extérieur de la structure réflective du côté de la surface latérale plane 26, dans l'espace adjacent à la deuxième face 23 interne de réflexion et dans l'espace adjacent à la troisième face 24 interne de réflexion.

Le premier et deuxième milieu 51,52 présentent un indice de réfraction strictement inférieur à l'indice de réfraction du matériau 21 transparent choisi pour la structure réflective (ou du matériau 13 du transducteur photo-électrique 30).

De préférence, le premier milieu 51 est formé d'un matériau diélectrique et le deuxième milieu 52 comprend de l'air.

Le matériau diélectrique est par exemple de l'oxyde de silicium.

Ainsi l'indice de réfraction du premier et du deuxième milieu 51,52 est proche de 1, alors que l'indice de réfraction de la structure réflective 20 et du transducteur photo-électrique 30 est 2,4. Le premier milieu diélectrique 51 forme alors un mur diélectrique 51 entourant la surface latérale parabolique de la structure réflective 20.

Une autre possibilité est que le premier et le deuxième milieu 51,52 sont tous deux formés d'un matériau diélectrique (non représenté sur les figures 1, 2 ou 3).

Pour terminer la description de la structure réflective 20, il convient de préciser qu'elle présente des dimensions latérales (cf. figure 2) de longueur Lsr1 selon l'axe optique Xₒᵢ, et de hauteur Lsr2 selon la droite y, ainsi qu'une hauteur Lsr3 (selon un axe perpendiculaire au plan du substrat 10, cf. figure 3).

Par exemple, la dimension latérale de longueur Lsr1 est de 1 micron et la dimension latérale de hauteur Lsr2 est 4 microns. La dimension latérale de hauteur Lsr2 est liée à la dimension latérale de longueur Lsr1 par l'équation de la parabole.

En référence à la figure 1, le guide d'onde 40 présente une extrémité 41 proximale, une extrémité 42 distale (non représentée sur la figure 1), et un axe longitudinal X_{g}.

Le guide d'onde 40 est formé d'un matériau 43 semiconducteur ayant un indice de réfraction, dit indice de réfraction du guide, du même ordre de grandeur que l'indice de réfraction du matériau 13 du transducteur photo-électrique 30. Le guide d'onde 40 est en outre entouré d'un ou plusieurs milieux 52, 12 ayant un indice de réfraction strictement inférieur à l'indice de réfraction du guide d'onde 40 (et du matériau 13 du transducteur photo-électrique).

Le guide d'onde 40 est par exemple formé en nitrure de silicium SiN.

De préférence, le guide d'onde 40 est formé du même matériau que le matériau 13 du transducteur photo-électrique 30 et comprend les puits quantiques 13b. Cela permet une continuité d'indice entre la région active, la structure réflective et le guide d'onde qui favorise un meilleur couplage de la lumière.

La disposition les uns par rapport aux autres du transducteur photo-électrique 30, de la structure réflective 20 et du guide d'onde 40 dans le système optique 1 est décrite ci-après.

En premier lieu, le transducteur photo-électrique 30 est agencé de sorte que la région active 32 est positionnée dans la structure réflective 20, au niveau d'une partie des foyers Fᵢ de la pluralité de sections paraboliques. Les dimensions latérales Le1 et Le2 de l'électrode supérieure 34 (et donc de la région active 32) sont au moins dix fois inférieures aux dimensions latérales de longueur et de hauteur Lsr1 et Lsr2 de la structure réflective 20.

En figure 1, la région active 32 occupe une zone correspondant à l'électrode supérieure 34. Celle-ci est positionnée latéralement au ou à proximité du foyer Fᵢ de la première face interne 22 de réflexion.

Ainsi, la face latérale arrière 321 de la région active est orientée vers la parabole formée par la première face interne 22 de réflexion.

En second lieu, le guide d'onde 40 est agencé de sorte que son axe longitudinal X_{g} soit parallèle aux axes optiques Xₒᵢ de la pluralité de sections paraboliques et que son extrémité proximale 41 soit accolée à la structure réflective 21 entre la deuxième et la troisième face interne 23,24 de réflexion (latéralement cf. figure 1) et au niveau de la région active 32 (verticalement, cf. figure 3). Le terme « accolé » désigne le fait que l'extrémité proximale 41 du guide d'onde 40 est au contact de la structure réflective et de la région active 32.

Lorsque le guide d'onde 40 est formé du même matériau 13 que le transducteur photo-électrique 30 et comprend les puits quantiques 13b, ceux-ci sont alignés avec l'axe longitudinal Xg du guide (cf. figure 3). Dans ce cas, le guide d'onde 30 est accolé à la structure réflective 20 et à la région active 32 par intégration monolithique.

En troisième lieu, les dimensions latérales Lsr1 et Lsr2 (cf. figure 2) de la structure réflective 20 sont strictement supérieures à la taille Lg2 du guide d'onde. Par exemple, la dimension latérale de hauteur Lsr2 de la structure réflective 20 est 4 microns pour une taille de guide Lg2 de 400 nm. Dans un autre exemple, la dimension latérale de hauteur Lsr2 de la structure réflective 20 est 4 microns pour une taille de guide Lg2 de 220 nm. La dimension latérale de hauteur Lsr2 est alors 18 fois supérieure à la taille Lg2 du guide d'onde 40.

Grâce aux éléments qui viennent d'être décrits et à leur arrangement particulier, le système optique 1 permet, dans chaque plan parallèle au substrat et sur toute la hauteur Lsr3 de la structure réflective 20, de canaliser les rayons lumineux provenant de la face arrière 321 de la région active 32 et de les diriger vers l'extrémité proximale 41 du guide d'onde 40. Il convient de noter qu'en l'absence de la structure réflective 20, ces rayons n'atteignent pas l'extrémité proximale 41 du guide d'onde 40. Ainsi, la luminosité (ou puissance optique) en sortie de l'ensemble formé par le transducteur photo-électrique et la structure réflective est accrue.

Le trajet suivi par les rayons lumineux provenant de la face arrière 321 de la région active 32 est illustré à l'aide des rayons r₁₀ et r₂₀ représentés en figure 1.

Comme la région active est placée au niveau des foyers de la première face 22 interne de réflexion, les rayons r₁₀ et r₂₀ sont réfléchis sur la première face 22 interne de réflexion parallèlement à l'axe optique Xₒᵢ. Cette première réflexion donne lieu aux rayons r₁₁ et r₂₁ représentés en figure 1.

Comme la deuxième et la troisième face de réflexion 23,24 sont planes et orthogonales au plan du substrat et au plan comportant les axes optiques de la pluralité de sections paraboliques, les rayons réfléchis une première fois r₁₂ et r₂₁ sont réfléchis une deuxième fois et redirigés dans la même direction, qui est donc parallèle à l'axe optique Xₒᵢ. Cette deuxième réflexion donne lieu aux rayons r₁₃ et r₂₃.

Enfin, ces rayons issus de deux réflexions successives se réfléchissent une troisième fois sur la première face 22 interne de réflexion. Comme ils arrivent sur la première face 22 interne de réflexion parallèlement à l'axe optique Xₒᵢ, les rayons réfléchis r₁₄ et r₂₄ sont dirigés vers le foyer Fᵢ devant lequel se situe l'extrémité 41 proximale du guide d'onde 40. On note que la zone de foyer Fᵢ dans laquelle sont concentrés les rayons réfléchis r₁₄ et r₂₄ présente des dimensions comparables à celles de la région active du transducteur photoélectrique. Cela permet d'utiliser un guide d'onde ayant une section de mêmes dimensions que celles de la région active, sans que cela détériore l'efficacité de couplage. Le fait de pouvoir utiliser un guide ayant une section de mêmes dimensions que celles de la région active offre la possibilité à la personne du métier de concevoir un guide monomode tout en gardant une efficacité de couplage importante.

Le fait que la dimension latérale de hauteur Lsr2 de la structure réflective 20 soit bien supérieure, par exemple 18 fois supérieure, à la taille Lg2 du guide d'onde 40 permet de canaliser des rayons émis avec un grand angle Θ par rapport à l'axe optique Xₒᵢ.

Le deuxième mode de réalisation illustré en figure 4 se distingue du premier mode de réalisation en deux points.

Tout d'abord, la première face interne 22 de réflexion est obtenue à l'aide d'un mur de matériau métallique 60 disposé dans le premier milieu 51 et à proximité de la première face 22 interne de réflexion. La première face interne 22 de réflexion travaille ainsi en réflexion totale.

Ensuite, le guide d'onde 40 présente une extrémité proximale 41 élargie et une forme d'entonnoir 44 au niveau de cette extrémité 41. Dans cette configuration, les dimensions latérales Le1, Le2 de la région active 32 sont adaptées à la taille de l'extrémité élargie 41, cela via la taille de l'électrode supérieure 34. Cette configuration est favorable à un meilleur couplage de la puissance optique incidente au niveau de l'extrémité 41 du guide.

Il convient de noter qu'une couche de matériau métallique (non représentée en figure 3) peut aussi être disposée dans le deuxième milieu 52, à proximité de la deuxième face 23 interne de réflexion et à proximité de la troisième face 24 interne de réflexion pour que les deuxième et troisième faces 24,25 travaillent également en réflexion totale.

Un deuxième aspect de l'invention concerne un procédé 500 de fabrication du système optique 1.

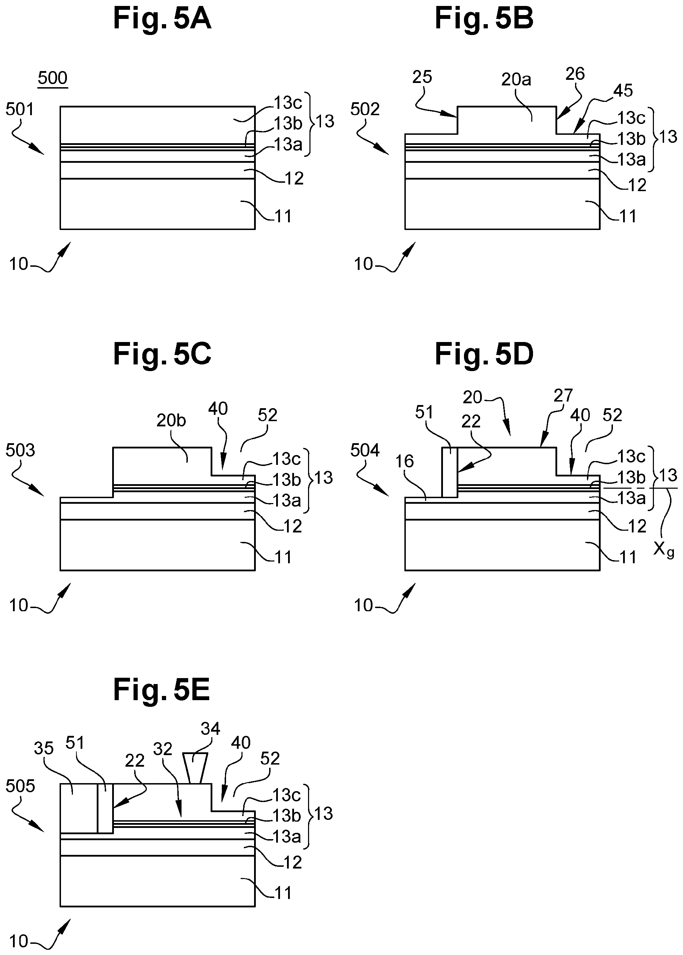

Les figures 5A à 5E illustrent en vue de coupe des étapes ou sous-étapes de fabrication du système optique de la figure 1, selon un mode de réalisation préférentiel.

Le procédé 500 débute à l'étape S501 illustrée en figure 5A avec la fourniture d'un substrat 10 comprenant la couche de substrat 11, la couche tampon 12 et la jonction P-N 13, celle-ci comprenant une couche inférieure N 13a, des puits quantiques 13b et une couche supérieure P connectées successivement de bas en haut. La jonction P-N 13 est par exemple obtenue par croissance épitaxiale et dopage.

Cette étape S501 se prolonge avec l'étape S502 représentée en figure 5B. L'étape S502 consiste à structurer en trois dimensions par lithographie la jonction P-N 13 pour créer des évidements et ainsi définir une face supérieure 45 du guide d'onde 40 et délimiter une partie des surfaces latérales de la structure réflective 20.

A l'issue de cette première structuration S502 en trois dimensions, un pilier 20a cylindro-parabolique conforme au pilier formant la structure réflective 20, est créé dans la jonction PN. Ce pilier 20a comprend ainsi la face latérale parabolique 25 et la face latérale plane 26 décrite précédemment.

L'étape S503 suit l'étape S502. Elle est illustrée en figure 5C. L'étape S503 est une étape de gravure verticale, aussi appelée gravure mesa, réalisée de part et d'autre du pilier 20a formé à l'étape S502 pour définir le guide d'onde 40 au niveau de la face latérale plane 26 du pilier 20a, pour compléter la définition du pilier cylindro-parabolique 20b formant la structure réflective 20, et pour définir la couche de liaison 16.

L'étape S503 de gravure verticale est suivie d'une étape S504 de passivation, illustrée en figure 5D, visant à déposer de façon conforme une couche diélectrique 51 sur la surface latérale parabolique 25 du pilier 20b. La surface latérale plane 26 ainsi que les faces latérales et supérieure du guide d'onde sont au contact de l'air 52.

La couche diélectrique 51 isole électriquement la surface latérale parabolique 26 de la structure réflective 20 en même temps qu'elle crée une interface entre le matériau 13 de la jonction P-N et le diélectrique, ceux-ci ayant des indices de réfraction très contrastés (2,4 par exemple pour une jonction P-N en GaN, et 1 pour le diélectrique).

A l'issue de l'étape S504, le substrat 10 porte le guide d'onde 40 et la structure réflective 20. La structure réflective comprend par ailleurs la première face 22 interne de réflexion et les deuxième et troisième faces internes de réflexion 23,24. Enfin, le guide d'onde est accolé latéralement à la structure réflective 20 au niveau de sa surface latérale plane 26, entre la deuxième et la troisième face interne 24,25 (non représentées sur la figure 5D) et au niveau des puits quantiques 13b, ceux-ci étant distribués le long de son axe longitudinal Xg. Une couche de liaison 16 reliée à la région inférieure 13a a aussi été définie du côté de la surface latérale parabolique 25 de la structure réflective 20.

L'étape S505 qui suit l'étape S504 de passivation est illustrée en figure 5E. Cette étape S505 consiste en la formation des électrodes supérieures 34 et inférieures 35.

Pour cela, un premier motif métallique 34 est formé sur la face supérieure du pilier cylindro-parabolique 20b, à proximité de la surface latérale plane 26, qui correspond au niveau des foyers de la première face interne 22 de réflexion.

Un deuxième motif métallique 35 en forme de mur est également formé sur la couche de liaison 16. Le mur 35 métallique peut ou non prendre la forme de la surface latérale parabolique 25.

Une combinaison de photolithographie, de dépôt et de retrait de résine peut être utilisé à cette étape S505.

A l'issue de cette étape S505, le transducteur photoélectrique est obtenu et le système optique 1 est finalisé.

Le procédé 500 qui vient d'être décrit concerne une intégration monolithique du guide d'onde, de la structure réflective et du transducteur photoélectrique.

Naturellement, ce procédé peut aussi être adapté dans le cas où le guide d'onde 40 et la structure réflective sont formés de matériaux différents du matériau du transducteur photo-électrique. Dans ce cas, l'étape S502 de structuration comprend une combinaison de sous-étapes de structuration et d'épitaxie permettant de définir 1) le transducteur photo-électrique, 2) le pilier cylindro-parabolique 20b et 3) la face supérieure 45 du guide d'onde 40.

## Revendications

1. Système optique (1) comprenant un substrat (1), une structure réflective (20), un transducteur photoélectrique (30) et un guide d'onde (40),
- la structure réflective (20) étant formée par un pilier cylindro-parabolique (20b) disposé sur le substrat (10), le pilier cylindro-parabolique étant délimité par une surface cylindrique comprenant une surface latérale parabolique (25) et une surface latérale plane (26), et par deux faces planes (27, 28) parallèles à un plan du substrat (10), et comprenant :
∘ une première face (22) interne de réflexion de profil parabolique disposée sur la surface latérale parabolique (25) de la surface cylindrique de la structure réflective, la première face (22) interne de réflexion étant définie par une pluralité de sections paraboliques parallèles au plan du substrat (10), chaque section parabolique étant définie par une parabole présentant un axe optique (Xₒᵢ) et un foyer (Fᵢ) et s'étendant depuis le sommet (Si) de la parabole jusqu'à la droite perpendiculaire (y) à l'axe optique (Xₒᵢ) et passant par le foyer (Fᵢ),
∘ une deuxième face (23) interne et une troisième face (24) interne de réflexion planes disposées sur la surface latérale plane (26) de la surface cylindrique de la structure réflective, la deuxième et troisième face interne de réflexion (23, 24) étant orthogonales au plan du substrat (10) et au plan comportant les axes optiques de la pluralité de sections paraboliques et situées de part et d'autre dudit plan comportant les axes optiques au niveau des foyers (Fᵢ) de la pluralité de sections paraboliques,
- le transducteur photoélectrique (30) comprenant une région active (32) configurée pour émettre des ondes lumineuses ou configurée pour recevoir des ondes lumineuses, et agencé de sorte que la région active (32) est positionnée dans la structure réflective (20), au niveau d'une partie des foyers (Fᵢ) de la pluralité de sections paraboliques, le matériau (21) de la structure réflective (20) étant choisi pour être transparent aux ondes lumineuses,
- le guide d'onde (40) présentant une extrémité proximale (41) , une extrémité distale (42) et un axe longitudinal (X_{g}) parallèle aux axes optiques (Xₒᵢ) de la pluralité de sections paraboliques, et agencé sur le substrat (10) de sorte que l'extrémité proximale (41) est accolée à la structure réflective (20), entre la deuxième et la troisième face (23,24) de réflexion et au niveau de la région active (32).

2. Système optique (1) selon la revendication 1 **caractérisé en ce qu'**un premier milieu (51) est disposé à l'extérieur de la structure réflective (20) dans un espace adjacent à la première face (22) interne de réflexion et un deuxième milieu (52) est disposé à l'extérieur de la structure réflective (20) et du guide d'onde (40) dans l'espace adjacent à la deuxième face (23) interne de réflexion et dans l'espace adjacent à la troisième face (24) interne de réflexion, le premier et deuxième milieu (51,52) présentant un indice de réfraction strictement inférieur à l'indice de réfraction du matériau (21) transparent choisi pour la structure réflective- (20).

3. Système optique (1) selon la revendication 2 **caractérisé en ce que** le premier milieu (51) est formé d'un matériau diélectrique et le deuxième milieu (52) comprend de l'air.

4. Système optique (1) selon la revendication 2 **caractérisé en ce que** le premier et le deuxième milieu (51,52) sont formés d'un matériau diélectrique.

5. Système optique selon l'une des revendications 3 à 4 **caractérisé en ce qu'**un mur (60) de matériau métallique est disposé dans le premier milieu (51) et à proximité de la première face (22) interne de réflexion.

6. Système optique (1) selon l'une des revendications 1 à 5 **caractérisé en ce que** le transducteur photoélectrique (30) est formé d'une jonction P-N (13) et de puits quantiques (13b) disposés dans la jonction P-N (13) et le matériau (21) transparent choisi pour la structure réflective (20) est le matériau (13) de la jonction P-N.

7. Système optique (1) selon la revendication 6 **caractérisé en ce que** le guide d'onde (40) est formé du matériau (13) de la jonction P-N et des puits quantiques (13b).

8. Système optique selon l'une des revendications 6 à 7 **caractérisé en ce que** le matériau (13) de la jonction P-N est un matériau III-V tel qu'un matériau à base de GaN.

9. Système optique (1) selon l'une des revendications 1 à 8 **caractérisé en ce que** le transducteur photoélectrique (30) comprend une électrode supérieure (34) et une électrode inférieure (35), l'électrode supérieure (34) étant positionnée sur la face plane supérieure (27) de la structure réflective (20) à l'aplomb de la zone prédéterminée (32) pour la région active, et présentant des dimensions latérales (Le1, Le2) correspondant aux dimensions prédéterminées pour la région active (32).

10. Système optique (1) selon l'une des revendications 1 à 9 **caractérisé en ce que** la structure réflective (20) présente une dimension latérale (Lsr2) de hauteur dans le plan du substrat (10) strictement supérieure à une taille (Lg2) du guide d'onde.

11. Système optique (1) selon l'une des revendications 1 à 10 **caractérisé en ce que** le guide d'onde (40) comprend une extrémité proximale (41) élargie par rapport aux dimensions (Lg2) du guide d'onde.

12. Procédé (500) de réalisation d'un système optique (1) selon l'une des revendications 1 à 11 comprenant les étapes de :
- Fourniture (S501) d'un substrat (10) comprenant une couche de substrat (11), une couche tampon (12) agencée sur la couche de substrat (11) et une jonction P-N (13) agencée sur la couche tampon (12),
- Structuration (S502) en trois dimensions de la jonction P-N (13) de sorte à définir une face supérieure (45) du guide d'onde (40) ainsi qu'une partie du pilier (20a) cylindro-parabolique formant la structure réflective (20), la structuration (S502) comprenant des sous-étapes de lithographie,
- Gravure verticale (S503) de la jonction P-N (13) de part et d'autre du pilier (20a) cylindro-parabolique formé pour compléter la définition du guide d'onde (40) et du pilier cylindro-parabolique (20b) formant la structure réflective (20), et définir une couche de liaison (16),
- Passivation (S504) par dépôt conforme du premier milieu (51) diélectrique à l'extérieur du pilier (20b) cylindro-parabolique, au niveau de la première face (22) interne de réflexion, pour obtenir la structure réflective (20),
- Formation (S505) d'une électrode supérieure (34) sur la face supérieure (27) de la jonction P-N au niveau des foyers (Fᵢ) de la pluralité de sections paraboliques, et d'une électrode inférieure (35) sur la couche de liaison (16) pour finaliser le transducteur photo-électrique (30) et le système optique (1).

## Patentansprüche

1. Optisches System (1) mit einem Substrat (1), einer reflektierenden Struktur (20), einem photoelektrischen Wandler (30) und einem Wellenleiter (40),
- wobei die reflektierende Struktur (20) durch eine zylindrisch-parabolische Säule (20b) gebildet wird, die auf dem Substrat (10) angeordnet ist, wobei die zylindrisch-parabolische Säule durch eine zylindrische Fläche begrenzt ist, die eine parabolische Seitenfläche (25) und eine ebene Seitenfläche (26) umfasst, sowie durch zwei ebene Flächen (27, 28), die parallel zu einer Ebene des Substrats (10) sind, und umfasst:
∘ eine erste innere Reflexionsfläche (22) mit parabolischem Profil, die auf der parabolischen Seitenfläche (25) der zylindrischen Fläche der reflektierenden Struktur angeordnet ist, wobei die erste innere Reflexionsfläche (22) durch eine Vielzahl von parabolischen Abschnitten definiert ist, die parallel zur Ebene des Substrats (10) verlaufen, wobei jeder parabolische Abschnitt durch eine Parabel definiert ist mit einer optischen Achse (Xₒᵢ) und einem Brennpunkt (Fᵢ) und sich vom Scheitelpunkt (Si) der Parabel bis zur Geraden erstreckt, die senkrecht (y) zur optischen Achse (Xₒᵢ) ist und durch den Brennpunkt (Fᵢ) verläuft,
∘ eine zweite innere Fläche (23) und eine dritte innere Reflexionsfläche (24), die auf der ebenen Seitenfläche (26) der zylindrischen Oberfläche der reflektierenden Struktur angeordnet sind, wobei die zweite und dritte innere Reflexionsfläche (23, 24) orthogonal zur Ebene des Substrats (10) und zur Ebene mit den optischen Achsen der Vielzahl von Parabolabschnitten sind und sich auf beiden Seiten der Ebene mit den optischen Achsen in Höhe der Brennpunkte (F(ᵢ) der Vielzahl von Parabolabschnitten befinden,
- wobei der photoelektrische Wandler (30) einen aktiven Bereich (32) umfasst, der so gestaltet ist, dass er Lichtwellen aussendet oder Lichtwellen empfängt, und so angeordnet ist, dass der aktive Bereich (32) in der reflektierenden Struktur (20) an einem Teil der Brennpunkte (Fᵢ) der Vielzahl von Parabolabschnitten angeordnet ist, wobei das Material (21) der reflektierenden Struktur (20) so gewählt ist, dass es für Lichtwellen transparent ist,
- wobei der Wellenleiter (40) ein proximales Ende (41), ein distales Ende (42) und eine Längsachse (X_{g}) parallel zu den optischen Achsen (Xₒᵢ) der Vielzahl von Parabolabschnitten aufweist und auf dem Substrat (10) so angeordnet ist, dass das proximale Ende (41) an der reflektierenden Struktur (20) zwischen der zweiten und der dritten Reflexionsfläche (23, 24) und auf Höhe des aktiven Bereichs (32) anliegt.

2. Optisches System (1) nach Anspruch 1, **dadurch gekennzeichnet, dass** ein erstes Medium (51) außerhalb der reflektierenden Struktur (20) in einem Raum neben der ersten inneren Reflexionsfläche (22) angeordnet ist und ein zweites Medium (52) außerhalb der reflektierenden Struktur (20) und des Wellenleiters (40) in dem an die zweite innere Reflexionsfläche (23) angrenzenden Raum und in dem an die dritte innere Reflexionsfläche (24) angrenzenden Raum angeordnet ist, wobei das erste und das zweite Medium (51, 52) einen Brechungsindex aufweisen, der streng kleiner ist als der Brechungsindex des für die reflektierende Struktur (20) ausgewählten transparenten Materials (21).

3. Optisches System (1) nach Anspruch 2, **dadurch gekennzeichnet, dass** das erste Medium (51) aus einem dielektrischen Material besteht und das zweite Medium (52) Luft umfasst.

4. Optisches System (1) nach Anspruch 2, **dadurch gekennzeichnet, dass** das erste und das zweite Medium (51, 52) aus einem dielektrischen Material bestehen.

5. Optisches System (1) nach einem der Ansprüche 3 bis 4, **dadurch gekennzeichnet, dass** eine Wand (60) aus metallischem Material in dem ersten Medium (51) und in der Nähe der ersten inneren Reflexionsfläche (22) angeordnet ist.

6. Optisches System (1) nach einem der Ansprüche 1 bis 5, **dadurch gekennzeichnet, dass** der photoelektrische Wandler (30) aus einem P-N-Übergang (13) und in dem P-N-Übergang (13) angeordneten Quantentöpfen (13b) gebildet ist und das für die reflektierende Struktur (20) ausgewählte transparente Material (21) das Material (13) des P-N-Übergangs ist.

7. Optisches System (1) nach Anspruch 6, **dadurch gekennzeichnet, dass** der Wellenleiter (40) aus dem Material (13) des P-N-Übergangs und den Quantentöpfen (13b) gebildet ist.

8. Optisches System nach einem der Ansprüche 6 bis 7, **dadurch gekennzeichnet, dass** das Material (13) des P-N-Übergangs ein III-V-Material wie beispielsweise ein Material auf GaN-Basis ist.

9. Optisches System (1) nach einem der Ansprüche 1 bis 8, **dadurch gekennzeichnet, dass** der photoelektrische Wandler (30) eine obere Elektrode (34) und eine untere Elektrode (35) umfasst, wobei die obere Elektrode (34) auf der oberen ebenen Fläche (27) der reflektierenden Struktur (20) senkrecht zu dem vorbestimmten Bereich (32) für den aktiven Bereich positioniert ist und seitliche Abmessungen (Le1, Le2) aufweist, die den vorbestimmten Abmessungen für den aktiven Bereich (32) entsprechen.

10. Optisches System (1) nach einem der Ansprüche 1 bis 9, **dadurch gekennzeichnet, dass** die reflektierende Struktur (20) eine seitliche Abmessung (Lsr2) in Höhe der Ebene des Substrats (10) aufweist, die streng größer ist als eine Größe (Lg2) des Wellenleiters.

11. Optisches System (1) nach einem der Ansprüche 1 bis 10, **dadurch gekennzeichnet, dass** der Wellenleiter (40) ein proximales Ende (41) aufweist, das im Vergleich zu den Abmessungen (Lg2) des Wellenleiters verbreitert ist.

12. Verfahren (500) zur Herstellung eines optischen Systems (1) gemäß einem der Ansprüche 1 bis 11, das die folgenden Schritte umfasst:
- Bereitstellen (S501) eines Substrats (10) mit einer Substratschicht (11), einer auf der Substratschicht (11) angeordneten Pufferschicht (12) und einem auf der Pufferschicht (12) angeordneten P-N-Übergang (13),
- dreidimensionales Strukturieren (S502) des P-N-Übergangs (13), um eine Oberseite (45) des Wellenleiters (40) sowie einen Teil der zylindrisch-parabolischen Säule (20a) zu definieren, die die reflektierende Struktur (20) bildet, wobei die Strukturierung (S502) Lithografie-Teilschritte umfasst,
- Vertikales Ätzen (S503) des P-N-Übergangs (13) auf beiden Seiten der zylindrisch-parabolischen Säule (20a), die gebildet wurde, um die Definition des Wellenleiters (40) und der zylindrisch-parabolischen Säule (20b), die die reflektierende Struktur (20) bildet, zu vervollständigen und eine Verbindungsschicht (16) zu definieren,
- Passivierung (S504) durch konformes Aufbringen des ersten dielektrischen Mediums (51) außerhalb der zylindrisch-parabolischen Säule (20b) auf Höhe der ersten inneren Reflexionsfläche (22), um die reflektierende Struktur (20) zu erhalten,
- Bildung (S505) einer oberen Elektrode (34) auf der Oberseite (27) des P-N-Übergangs auf Höhe der Brennpunkte (Fᵢ) der Vielzahl von parabolischen Abschnitten und einer unteren Elektrode (35) auf der Verbindungsschicht (16), um den photoelektrischen Wandler (30) und das optische System (1) fertigzustellen.

## Claims

1. An optical system (1) comprising a substrate (1), a reflective structure (20), a photoelectric transducer (30) and a waveguide (40),
- the reflective structure (20) being formed by a cylindro-parabolic pillar (20b) disposed on the substrate (10), the cylindro-parabolic pillar being delimited by a cylindrical surface comprising a parabolic side surface (25) and a planar side surface (26), and by two planar faces (27, 28) parallel to a plane of the substrate (10), and comprising:
∘ a first inner reflection face (22) with a parabolic profile disposed on the parabolic side surface (25) of the cylindrical surface of the reflective structure, the first inner reflection face (22) being defined by a plurality of parabolic sections parallel to the plane of the substrate (10), each parabolic section being defined by a parabola having an optical axis (Xₒᵢ) and a focus (Fᵢ) and extending from the vertex (Si) of the parabola to the straight line perpendicular (y) to the optical axis (Xoi) and passing through the focus (Fᵢ),
∘ a second inner planar reflection face (23) and a third inner planar reflection face (24) disposed on the planar side surface (26) of the cylindrical surface of the reflective structure, the second and third inner reflection faces (23, 24) being orthogonal to the plane of the substrate (10) and to the plane including the optical axes of the plurality of parabolic sections and located on either side of said plane including the optical axes at the foci (Fi) of the plurality of parabolic sections,
- the photoelectric transducer (30) comprising an active region (32) configured to emit light waves or configured to receive light waves, and arranged so that the active region (32) is positioned in the reflective structure (20), at a part of the foci (Fi) of the plurality of parabolic sections, the material (21) of the reflective structure (20) being chosen to be transparent to light waves,
- the waveguide (40) having a proximal end (41), a distal end (42) and a longitudinal axis (Xg) parallel to the optical axes (Xₒᵢ) of the plurality of parabolic sections, and arranged on the substrate (10) so that the proximal end (41) is adjoining the reflective structure (20), between the second and third reflection faces (23, 24) and at the active region (32).

2. The optical system (1) according to claim 1, **characterised in that** a first medium (51) is disposed outwardly of the reflective structure (20) in a space adjacent to the first inner reflection face (22) and a second medium (52) is disposed outwardly of the reflective structure (20) and the waveguide (40) in the space adjacent to the second inner reflection face (23) and in the space adjacent to the third inner reflection face (24), the first and second media (51, 52) having a refractive index strictly lower than the refractive index of the transparent material (21) chosen for the reflective structure (20).

3. The optical system (1) according to claim 2, **characterised in that** the first medium (51) is formed by a dielectric material and the second medium (52) comprises air.

4. The optical system (1) according to claim 2, **characterised in that** the first and second media (51,52) are formed by a dielectric material.

5. The optical system according to one of claims 3 to 4, **characterised in that** a wall (60) of metal material is disposed in the first medium (51) and in proximity to the first inner reflection face (22).

6. The optical system (1) according to one of claims 1 to 5, **characterised in that** the photoelectric transducer (30) is formed by a P-N junction (13) and quantum wells (13b) disposed in the P-N junction (13) and the transparent material (21) chosen for the reflective structure (20) is the material (13) of the P-N junction.

7. The optical system (1) according to claim 6, **characterised in that** the waveguide (40) is formed by the material (13) of the P-N junction and the quantum wells (13b).

8. The optical system according to one of claims 6 to 7, **characterised in that** the material (13) of the P-N junction is a III-V material such as a GaN-based material.

9. The optical system (1) according to one of claims 1 to 8, **characterised in that** the photoelectric transducer (30) comprises an upper electrode (34) and a lower electrode (35), the upper electrode (34) being positioned on the upper face (27) of the reflective structure (20) in vertical alignment with the predetermined zone (32) for the active region, and having lateral dimensions (Le1, Le2) corresponding to the predetermined dimensions for the active region (32).

10. The optical system (1) according to one of claims 1 to 9, **characterised in that** the reflective structure (20) has a lateral height dimension (Lsr2) in the plane of the substrate (10) strictly greater than a size (Lg2) of the waveguide.

11. The optical system (1) according to one of claims 1 to 10, **characterised in that** the waveguide (40) comprises a proximal end (41) enlarged relative to the dimensions (Lg2) of the waveguide.

12. A method (500) for making an optical system (1) according to one of claims 1 to 11, comprising the steps of:
- Providing (S501) a substrate (10) comprising a substrate layer (11), a buffer layer (12) arranged on the substrate layer (11) and a P-N junction (13) arranged on the buffer layer (12),
- three-dimensionally structuring (S502) the P-N junction (13) so as to define an upper face (45) of the waveguide (40) as well as a part of the cylindro-parabolic pillar (20a) forming the reflective structure (20), structuring (S502) comprising lithography sub-steps,
- Vertically etching (S503) the P-N junction (13) on either side of the cylindro-parabolic pillar (20a) formed to complete definition of the waveguide (40) and of the cylindro-parabolic pillar (20b) forming the reflective structure (20), and to define a bonding layer (16),
- Passivating (S504) the first dielectric medium by conformal deposition (51) outwardly of the cylindro-parabolic pillar (20b), at the first inner reflection face (22), to obtain the reflective structure (20),
- forming (S505) an upper electrode (34) on the upper face (27) of the P-N junction at the foci (Fi) of the plurality of parabolic sections, and a lower electrode (35) on the bonding layer (16) to complete the photoelectric transducer (30) and the optical system (1).
